(19) Europäisches Patentamt
European Patent Office
Office européen des brevets

(11) **EP 1 570 575 B1**

(12) **EUROPÄISCHE PATENTSCHRIFT**

(45) Veröffentlichungstag und Bekanntmachung des Hinweises auf die Patenterteilung:
**02.06.2010 Patentblatt 2010/22**

(21) Anmeldenummer: **03785535.0**

(22) Anmeldetag: **25.11.2003**

(51) Int Cl.:
***H03L 7/00*** *(2006.01)*

(86) Internationale Anmeldenummer:
**PCT/DE2003/003894**

(87) Internationale Veröffentlichungsnummer:
**WO 2004/054108 (24.06.2004 Gazette 2004/26)**

(54) **PHASENREGELSCHLEIFE MIT SIGMA-DELTA-MODULATOR**

PHASE-LOCKED LOOP COMPRISING A SIGMA-DELTA MODULATOR

BOUCLE DE R GULATION PHASES AVEC MODULATEUR SIGMA -DELTA

(84) Benannte Vertragsstaaten:
**DE**

(30) Priorität: **06.12.2002 DE 10257185**

(43) Veröffentlichungstag der Anmeldung:
**07.09.2005 Patentblatt 2005/36**

(73) Patentinhaber: **Infineon Technologies AG**
**85579 Neubiberg (DE)**

(72) Erfinder:
• **LI PUMA, Giuseppe**
**44791 Bochum (DE)**
• **WAGNER, Elmar**
**47269 Duisburg (DE)**

(74) Vertreter: **Viering, Jentschura & Partner**
**Postfach 22 14 43**
**80504 München (DE)**

(56) Entgegenhaltungen:
**WO-A-02/27936     GB-A- 2 252 879**
**US-A- 6 008 703**

**Beschreibung**

Die vorliegende Erfindung betrifft eine Phasenregelschleife mit $\Sigma\Delta$(Sigma-Delta)-Modulator, aufweisend einen Phasenvergleicher mit zwei Eingängen und einem Ausgang, einen gesteuerten Oszillator mit einem Steuereingang, der an den Ausgang des Phasenvergleichers angekoppelt ist, einen Frequenzteiler mit einem Signaleingang, der an einen Ausgang des gesteuerten Oszillators angekoppelt ist, mit einem Ausgang und mit einem Steuereingang zur Vorwahl des Teilerverhältnisses des Frequenzteilers und aufweisend den Sigma-Delta-Modulator, der mit dem Steuereingang des Frequenzteilers verbunden ist.

Eine gattungsgemäße Phasenregelschleife, englisch PLL, Phase Locked Loop, ist in der Druckschrift US 6,008,703 angegeben. Dort ist ein Frequenz-Synthesizer beschrieben, bei dem mit einer $\Sigma\Delta$-PLL ein Signal mit modulierter Trägerfrequenz erzeugt wird. Diese Phasenregelschleife, welche in der angegebenen Druckschrift beispielsweise in Figur 2A gezeigt ist, umfaßt einen Vorwärtszweig mit Phasendetektor, Schleifenfilter und gesteuertem Oszillator und einen Rückwärtszweig, der den Ausgang des Oszillators über einen Multi-Modulus-Teiler mit dem Phasendetektor koppelt. Zur Steuerung des Multi-Modulus-Teilers ist ein digitaler Sigma-Delta-Modulator vorgesehen, der eingangsseitig sowohl mit Informationen über das gewünschte Trägersignal, als auch mit digitalen Modulationsdaten gespeist wird. Das modulierte Ausgangssignal wird am Ausgang des gesteuerten Oszillators bereitgestellt.

Die gewünschte Frequenzmodulation erfolgt bei einem gattungsgemäßen Phasenregelkreis digital über die Variation des Frequenzteilerwertes. Derartige Frequenz-Synthesizer werden beispielsweise in modernen, digitalen Funksystemen zur Trägerfrequenzerzeugung und zur digitalen Frequenzmodulation eingesetzt.

Bei der Dimensionierung oder Auslegung einer derartigen Phasenregelschleife ist die Wahl der Bandbreite der Phasenregelschleife von besonders großer Bedeutung. Dabei muß ein Kompromiß gefunden werden zwischen den Rauscheigenschaften der Schaltung und der Modulationsbandbreite. Einerseits soll das Rauschen möglichst gering sein, um die in den verschiedenen Funkspezifikationen vorgeschriebenen, spektralen Sendemasken einzuhalten. Dies bedingt die Auswahl einer verhältnismäßig geringen Schleifenbandbreite. Dem steht andererseits entgegen, dass die Übertragung modulierter Daten bei modernen Anwendungen in der Nachrichtentechnik eine hohe Bandbreite erfordert.

Beispielsweise in dem europäischen Telekommunikations-Standard "ETSI EN 300 175-2 V1.5.1 (2001-02) DECT(Digital Enhanced Cordless Telecommunications) CI(Common Interface) PART 2: Physical Layer" sind Grenzen für unerwünschte Funk-Emissionen angegeben. Beispielsweise ist der maximale Leistungspegel für den dritten und vierten Nachbarkanal auf 80nW beziehungsweise 40nW begrenzt, siehe Kapitel 5.5, Seite 24.

Ein systembedingter, dominanter Rauschanteil entsteht durch das Quantisierungsrauschen des $\Sigma\Delta$-Modulators selbst. Der $\Sigma\Delta$-Modulator steuert normalerweise den Multi-Modulus-Teiler an und bewirkt dabei ein zufälliges Umschalten zwischen ganzzahligen Teilerverhältnissen, um im Mittel dasjenige Teilerverhältnis zu erhalten, welches die Erzeugung der gewünschten Ausgangsfrequenz der PLL bewirkt.

In der eingangs genannten Druckschrift US 6,008,703 ist ein Multi-Modulus-Teiler in Figur 10A gezeigt, der eine Serienschaltung mehrerer Frequenzteilerstufen umfaßt. Die Frequenzteilerstufen sind dabei jeweils zwischen genau zwei Teilerwerten umschaltbar und können die Eingangsfrequenz entweder durch den Teilerwert zwei oder durch den Teilerwert drei teilen. Derartige Frequenzteilerstufen werden auch als 2/3-Frequenzteiler bezeichnet. Der Bereich der einstellbaren Teilerwerte eines derartigen Multi-Modulus-Teilers, der nur aus 2/3-Teilerstufen aufgebaut ist, bestimmt sich gemäß der Vorschrift

$$N = N_o + \sum_{i=0}^{L-1} c_i \cdot 2^i$$

wobei L die Anzahl der 2/3-Teilerstufen bezeichnet und $N_0$ gleich $2^L$.

Der einen derartigen Multi-Modulus-Teiler ansteuernde $\Sigma\Delta$-Modulator wird normalerweise in einer sogenannten MASH-Architektur implementiert. Eine Stufe eines derartigen, mehrstufigen MASH-Modulators ist beispielhaft in Figur 8B der eingangs beschriebenen Druckschrift US 6,008,703 gezeigt. Dabei ist ein Summierglied vorgesehen mit zwei Eingängen und einem Ausgang, wobei ein Fehlersignal mit einem Rückkopplungspfad zurückgekoppelt wird. Das Fehlersignal wird dabei normalerweise verzögert zurückgespeist. Ein mehrstufiger $\Sigma\Delta$-Modulator mit MASH-Architektur ist in Figur 8A anhand eines Blockschaltbildes beschrieben.

Der $\Sigma\Delta$-Modulator verteilt die Leistung des Quantisierungsrauschens gemäß seiner Rauschübertragungsfunktion über das Frequenzband. Die Rauschübertragungsfunktion, englisch: NTF, Noise Transfer Function der MASH-Struktur kann durch die Gleichung

$$NTF(z) = (1 - z^{-1})^N$$

beschrieben werden, wobei N die Ordnung des Modulators repräsentiert. Das Quantisierungsrauschen wird dabei von tieferen zu höheren Frequenzen verschoben. Die Ansteuerung des Multi-Modulus-Teilers durch den $\Sigma\Delta$-Modulator bewirkt ein zufälliges Umschalten der Teilerwerte gemäß der spektralen Verteilung des Quantisierungsrauschens. Das zufällige Umschalten des Teilungsfaktors bewirkt wiederum eine zeitliche Änderung der Frequenz und erzeugt somit einen sogenannten Frequenz- oder Phasenstörhub (FM- oder PM-Störhub). Dieser wird in der Literatur auch als Rest-FM-Jitter, englisch: residual FM, oder auch als Phasenrauschen bezeichnet. Die Größe dieses Störhubes bestimmt das Signal-zu-Rausch-Verhältnis, englisch: SNR, Signal to Noise Ratio des frequenz- beziehungsweise phasenmodulierten Trägersignals und hat daher signifikante Auswirkungen auf die Leistungsfähigkeit eines derart ausgestalteten Funkempfängers, wie beispielsweise dessen Reichweite.

Bei dem Frequenz-Synthesizer gemäß US 6,008,703 wird aufgrund der erläuterten Rauschanforderungen die Bandbreite der Phasenregelschleife deutlich kleiner ausgelegt, als es die Übertragung der modulierten Daten eigentlich erfordert. Um den dadurch bedingten Frequenzgang des Schleifenfilters in der PLL zu kompensieren, werden die zu modulierenden Daten vor der Zuführung zu dem $\Sigma\Delta$-Modulator digital vorkompensiert. Dabei werden hohe Frequenzanteile digital angehoben.

Ein wesentlicher Nachteil dieses Konzeptes ist die erforderliche, sehr genaue Anpassung zwischen dem digitalen Kompensationsfilter einerseits und dem analogen Schleifenfilter andererseits. Wenn sich nämlich die Bandbreite der Regelschleife durch analoge Einflüsse wie Fertigungstoleranzen, Temperaturdrifts oder Alterungserscheinungen verändert, bewirkt die digitale Vorkompensation, die diesen Einflüssen praktisch nicht unterworfen ist, eine zu starke oder zu schwache Anhebung der hohen Frequenzanteile.

Die Druckschrift WO02/27936 beschreibt eine Phaseregelschleife mit einem Sigma-Delta-Modulator, der einen Rückfürungszweig mit einer Übertragungsfunktion $1-(1-z^{-1})^N$ umfasst.

Eine andere Möglichkeit zur Kompensation einer reduzierten Schleifenbandbreite ist durch die sogenannte Zweipunktmodulation gegeben. Bei dieser erfolgt die Modulation an zwei Modulationspunkten der Phasenregelschleife, einerseits am Frequenzteiler und andererseits am Oszillatoreingang. Dabei hat einer der beiden Modulationspunkte der PLL Tiefpaß-, der an-dere Hochpaß-Eigenschaften. Somit ergibt sich in der Summe eine konstante Übertragungsfunktion für die Modulationsdaten. Auch hier ergibt sich jedoch die bereits erläuterte Problematik der erforderlichen genauen Anpassung zwischen analogem und digitalem Signalpfad.

Aufgabe der vorliegenden Erfindung ist es, eine Phasenregelschleife mit $\Sigma\Delta$-Modulator anzugeben, die eine große Modulationsbandbreite bietet, die Einhaltung spektraler Sendemasken wie in Mobilfunkstandards vorgesehen ermöglicht und dennoch die Problematik von Fehlanpassungen zwischen analogen und digitalen Schaltungsteilen vermeidet.

Erfindungsgemäß wird die Aufgabe gelöst durch Weiterbildung einer gattungsgemäßen Phasenregelschleife mit $\Sigma\Delta$-Modulator dahingehend, dass der $\Sigma\Delta$-Modulator einen Rückführungszweig umfaßt, der den Ausgang eines Summiergliedes mit einem Eingang desselben koppelt, und der so ausgelegt ist, dass die den Rückführungszweig repräsentierende, komplexe Übertragungsfunktion ein komplexes, von Null verschiedenes Polstellenpaar in der Laplace-Ebene aufweist.

Es können dabei in der den Rückführungszweig repräsentierenden, komplexen Übertragungsfunktion auch mehrere komplexe, von Null verschiedene Polstellenpaare in der Laplace-Ebene vorgesehen sein.

Das beschriebene Prinzip beruht auf der sogenannten Error-Feedback-Topologie einer $\Sigma\Delta$-Architektur. Gegenüber einer eingangs erläuterten MASH-Struktur, die gemäß ihrer Übertragungsfunktion in der Laplace-Ebene

$$H(s) = 1/s^3$$

eine dreifache Polstelle bei s = 0 besitzt, wird gemäß dem vorgeschlagenen Prinzip eine Übertragungsfunktion mit zumindest einem konjugiert komplexen Polstellenpaar implementiert.

Durch geeignete Wahl von Imaginär- und Realteil des komplexen Polstellenpaares kann problemlos die Einhaltung der in FunkSpezifikationen geforderten, spektralen Sendemasken gewährleistet werden.

Mit der beschriebenen, komplexen Übertragungsfunktion H(s) in der Laplace-Ebene bestimmt sich die zugehörige Rauschübertragungsfunktion zu

$$\text{NTF(z)} = 1 - \text{H(z)}.$$

Das gemäß dem vorgeschlagenen Prinzip eingefügte komplexe Polpaar, welches von Null verschieden ist, bewirkt, dass das Rauschen in einem kritischen Frequenzbereich abgesenkt werden kann. Der Imaginärteil des zusätzlichen, komplexen Polstellenpaares bestimmt dabei die Frequenzablage, während der Realteil die Unterdrückung des Rauschens bei dieser Frequenzablage festlegt.

Mit der vorgeschlagenen Architektur gelingt es, eine Rauschübertragungsfunktion zu dimensionieren, die speziell unter Berücksichtigung der Anforderungen bezüglich der spektralen Sendemaske optimiert werden kann.

Beispielsweise im DECT-System, Digital Enhanced Cordless Telecommunication, sind normalerweise die Anforderungen an die spektrale Leistungsaussendung im Frequenzabstand bei 4 MHz bis 8 MHz kritisch bezüglich der Einhaltung, was dem dritten und vierten Nachbarkanal entspricht, da einerseits das ΣΔ-Quantisierungsrauschen noch stark ansteigt und durch das Schleifenfilter nicht ausreichend gedämpft wird und andererseits die ausgestrahlte Leistung im Nachbarkanal nur 80 bzw. 40 nW betragen darf, entsprechend drittem und viertem Nachbarkanal. Dies ist in der eingangs zitierten ETSI-Norm bezüglich der physikalischen Ebene im DECT-Standard festgelegt.

Gemäß dem vorgeschlagenen Prinzip können Sendeanordnungen mit der Phasenregelschleife zur Erzeugung frequenz- bzw. phasenmodulierter Signale bereitgestellt werden. Die beschriebene Phasenregelschleife ist aber auch als Frequenz-Synthesizer zur Bereitstellung einer Trägerfrequenz verwendbar.

Mit dem beschriebenen Prinzip wird die volle Modulationsbandbreite über die Phasenregelschleife übertragen. Die Bandbreite der Phasenregelschleife ist hierbei mit Vorteil so groß wie die Modulationsbandbreite. Damit können die hohen Matching-Anforderungen bekannter Sendekonzepte zwischen der analogen Phasenregelschleife und dem digitalen Signalverarbeitungsteil des ΣΔ-PLL umgangen werden.

Zur Ermöglichung der hohen Phasenregelkreisbandbreite wird, zusammengefasst formuliert, ein ΣΔ-Modulator unter Berücksichtigung der spektralen Sendemaske verwendet. Hierzu wird wie erläutert gemäß vorgeschlagenem Prinzip in der Rauschübertragungsfunktion im kritischen Nachbarkanal eine komplexe Nullstelle eingefügt, die dazu führt, dass die Sendemaske trotz der höheren Bandbreite eingehalten wird.

Gemäß einer bevorzugten Weiterbildung der Erfindung besitzt die in Abhängigkeit von der Laplace-Variablen s beschriebene, komplexe Übertragungsfunktion H(s) neben dem komplexen Polstellenpaar eine doppelte Polstelle bei dem Wert s = 0.

Beispielsweise genügt die komplexe Übertragungsfunktion des Rückführungszweiges bevorzugt der Gleichung

$$H(s) = \frac{1}{s^2 \cdot (s + \sigma_1 + j\omega_1) \cdot (s + \sigma_2 - j\omega_2)}$$

oder allgemeiner:

$$H(s) = \frac{1}{\prod_{i=0}^{n}(s + \sigma_i \pm j\omega_i)} \; ,$$

wobei $\sigma_i$ kleiner oder gleich Null ist und zumindest ein $\sigma_i$ von Null verschieden ist.

Gemäß einer weiteren, bevorzugten Ausführungsform des vorliegenden Prinzips ist der Frequenzteiler als sogenannter Multi-Modulus-Teiler ausgeführt. Der Multi-Modulus-Teiler kann beispielsweise einen Bereich einstellbarer Teilerwerte von 32 bis 63 haben. Dadurch kann mit der Phasenregelschleife mit Modulator ein weiter Frequenzbereich abgedeckt werden.

Gemäß einer Weiterbildung der vorliegenden Erfindung ist ein weiterer Frequenzteiler am Ausgang des gesteuerten Oszillators vorgesehen. Der weitere Frequenzteiler hat dabei mehrere Ausgänge, an denen jeweils zueinander phasenverschobene Signale bereitgestellt werden.

Der Ausgang der Phasenregelschleife ist dabei am Ausgang des weiteren Frequenzteilers, nicht unmittelbar am Ausgang des gesteuerten Oszillators, gebildet. Der Oszillator schwingt auf einer dem Frequenzteilerverhältnis des weiteren Frequenzteilers entsprechenden, höheren Frequenz.

Weiterhin ist bevorzugt ein Multiplexer vorgesehen mit mehreren Eingängen. Dabei ist jedem Ausgang des weiteren Frequenzteilers ein Eingang am Multiplexer zugeordnet, und jeweils damit verbunden. Der Ausgang des Multiplexers ist an den Eingang des Multi-Modulus-Teilers angeschlossen.

Gemäß der vorgeschlagenen Weiterbildung wird dem Multi-Modulus-Teiler das Ausgangssignal der Phasenregelschleife mit einer wählbaren Phasenverschiebung zugeführt. Dies bewirkt eine Reduktion der Teilerschrittweite $\Delta N$ auf Werte kleiner 1 bezogen auf die Ausgangsfrequenz, so dass das Quantisierungsrauschen über einen kleineren Frequenzbereich verteilt wird und somit zu einem reduzierten Störhub führt. Dies führt zu einer weiteren Verbesserung der Möglichkeiten zur Einhaltung der spektralen Sendemaske eines Mobilfunkstandards.

Der Steuereingang des Multiplexers ist bevorzugt mit dem $\Sigma\Delta$-Modulator zur Vorwahl der Phasenverschiebung verbunden.

Der weitere Frequenzteiler ist bevorzugt als :2-Frequenzteiler ausgelegt. Dabei entspricht die Frequenz des vom gesteuerten Oszillator an dessen Ausgang bereitgestellten Signals der doppelte Ausgangsfrequenz der Phasenregelschleife.

Der weitere Frequenzteiler hat bevorzugt vier Ausgänge, an denen das Signal mit der Ausgangsfrequenz der Phasenregelschleife in Schritten von 90° zueinander phasenverschoben bereitsteht. Hierdurch wird die Teilerschrittweite $\Delta N$ reduziert von 1 auf 0,25 bezogen auf die Ausgangsfrequenz der PLL.

Gemäß einer weiteren, bevorzugten Weiterbildung der Erfindung umfaßt der Multi-Modulus-Teiler eine Serienschaltung mehrerer 2/3-Frequenzteilerstufen, bei denen jeweils zwischen einem Frequenzteilerverhältnis von 2 und einem Frequenzteilerverhältnis von 3 umgeschaltet werden kann. Das Frequenzteilerverhältnis von 2 entspricht dabei einer Frequenzhalbierung. Das Frequenzteilerverhältnis von 3 bedeutet eine Division der Eingangssignalfrequenz durch 3.

In der Phasenregelschleife ist bevorzugt zur Kopplung des Phasenvergleichers mit dem gesteuerten Oszillator eine Ladungspumpenschaltung mit nachgeschaltetem Schleifenfilter vorgesehen. Das Schleifenfilter ist dabei bevorzugt für eine Schleifenbandbreite ausgelegt, die gleich der Modulationsbandbreite ist.

Weitere Einzelheiten und vorteilhafte Ausgestaltungen des vorgeschlagenen Prinzips sind Gegenstand der Unteransprüche.

Die Erfindung wird nachfolgend an Ausführungsbeispielen anhand der Zeichnungen näher erläutert.

Es zeigen:

Figur 1      ein Blockschaltbild einer Phasenregelschleife mit $\Sigma\Delta$-Modulation eines Ausführungsbeispiels des erfin- dungsgemäßen Prinzips,

Figur 2      anhand eines Schaubildes die Sendemaske gemäß DECT- Spezifikation sowie den Frequenzverlauf gemäß vor- geschlagenem Prinzip und Stand der Technik, wobei die spektralen Leistungsdichte aufgetragen ist über der Frequenz, und

Figur 3      ein Ausführungsbeispiel eines $\Sigma\Delta$-Modulators 4. Ord- nung gemäß Figur 1 mit einer Rauschübertragungs-funktion gemäß Figur 2.

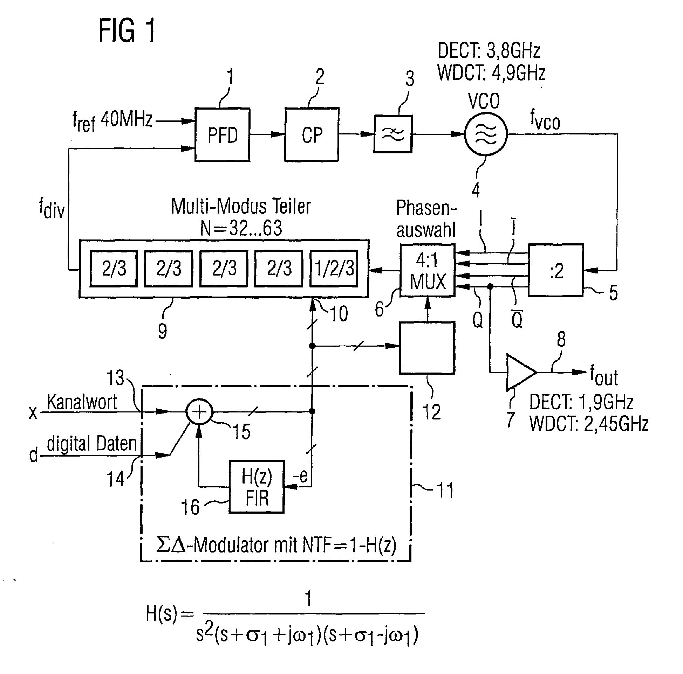

Figur 1 zeigt einen Phasenregelkreis mit einem Phasenvergleicher 1 mit zwei Eingängen und einem Ausgang. An einem der beiden Eingängen des Phasendetektors oder Phasenvergleichers 1 ist ein Referenzfrequenzgenerator anschließbar, hier nicht eingezeichnet, der eine Bezugsfrequenz $F_{ref}$ liefert. An den Ausgang des Phasendetektors 1 ist über eine Ladungspumpenschaltung 2 und ein der Ladungspumpenschaltung 2 nachgeschaltetes Schleifenfilter 3, welches als Tiefpaß ausgelegt ist, ein spannungsgesteuerter Oszillator 4 angeschlossen. An den Ausgang des Oszillators 4 ist über einen :2-Frequenzteiler 5 ein 4:1-Multiplexer 6 angeschlossen. Der :2-Frequenzteiler 5 hat vier Ausgänge, an denen das Signal mit der Ausgangsfrequenz $F_{out}$ des Phasenregelkreises in vier verschiedenen Phasenlagen abgreifbar ist. Einer der vier Ausgänge des Frequenzteilers 5 bildet über einen Verstärker 7 den Ausgang 8 des Phasenregelkreises.

Die vier Ausgänge des Frequenzteilers 5 sind mit je einem zugeordneten Eingang des Multiplexers 6 verbunden, der in einem Rückkopplungspfad des Phasen-Regelkreises angeordnet ist. Der Ausgang des Multiplexers 6 ist über einen Multi-Modulus-Teiler 9 an einen weiteren Eingang des Phasen-Detektors 1 angeschlossen. Der Multi-Modulus-Teiler 9 umfaßt eine Serienschaltung aus insgesamt fünf Frequenzteilerstufen. Jede Frequenzteilerstufe ist als 2/3-Frequenzteiler aufgebaut, bei der der Frequenzteilerwert umschaltbar ist zwischen 2 und 3. Die Steuereingänge der Frequenzteilerstufen sind zu einem Programmiereingang 10 des Multi-Modulus-Teilers 9 zusammengefaßt. An dem Programmiereingang 10 ist der gewünschte Frequenzteilerwert des Multi-Modulus-Teilers in einem Bereich N von 32 bis 63 einstellbar. Der Programmiereingang 10 ist mit dem Ausgang eines $\Sigma\Delta$-Modulators 11 verbunden. An den Ausgang des $\Sigma\Delta$-Modulators 11 ist auch, über eine Steuereinheit 12, der Steuereingang des Multiplexers 6 angeschlossen.

Der $\Sigma\Delta$-Modulator 11 umfaßt einen ersten Eingang 13 zum Zuführen eines Kanalwortes, das heißt der Information über den einzustellenden Kanal des Phasenregelkreises. Ein weiterer Eingang 14 dient zum Zuführen der digitalen Modulationsdaten. Beide Eingänge 13, 14 werden in einem Summierglied 15 miteinander und mit einem Rückführungspfad verbunden. Der Rückführungspfad führt den Ausgang des Summiergliedes 15 über ein FIR-Filter 16 an einen Eingang des Summiergliedes zurück. Das FIR-Filter 16 weist eine Übertragungsfunktion H(z) auf, welche komplex ist. In der Laplace-Ebene läßt sich durch Transformation die Übertragungsfunktion H(s) beschreiben durch die Formel

$$H(s) = \frac{1}{s^2 \cdot (s + \sigma_1 + j\omega_1) \cdot (s + \sigma_2 - j\omega_2)}$$

Die Rauschübertragungsfunktion NTF des $\Sigma\Delta$-Modulators 11 bestimmt sich dabei in der z-Ebene aus NTF(z) = 1 - H(z).

Bei der vorgeschlagenen $\Sigma\Delta$-fractional N-PLL schwingt der Oszillator 4 auf der doppelten Ausgangsfrequenz $f_{out}$. Gesteuert wird der Oszillator 4 durch ein Vergleichsergebnis einer Bezugsfrequenz $f_{ref}$ und der vom Multi-Modulus-Teiler 9 bereitgestellten, heruntergeteilten Frequenz $f_{div}$. Im Vorwärtspfad 1, 2, 3, 4, 5 des Phasenregelkreises ist ein zusätzlicher Frequenzteiler 5 vorgesehen. Dieser stellt die Ausgangsfrequenz in vier verschiedenen Phasenlagen bereit, zwischen denen mit Multiplexer 6 ausgewählt werden kann. Bezogen auf die Ausgangsfrequenz $f_{out}$ der PLL ergibt sich damit eine auf das Teilerverhältnis bezogene Schrittweite $\Delta N$, die kleiner als 1 ist. Mit der vorgeschlagenen PLL ist es möglich, nicht nur in Frequenzschritten umzuschalten, die durch die Bezugsfrequenz $f_{ref}$ vorgegegeben sind, im vorliegenden Fall 40 MHz, sondern in durch den Faktor 0,25 bedingten Schrittweiten von 10 MHz.

Mit der geringeren Schrittweite variiert die Momentanfrequenz über einen kleineren Frequenzbereich, so dass sich auch das Quantisierungsrauschen um den Faktor der Teilerschrittverkleinerung verringert. Bei Verwendung von vorliegend vier verschiedenen Phasenlagen wird eine Reduzierung des Störhubes um den Faktor 4 erzielt, was einer spektralen Absenkung des Phasenrauschens um 12 dB entspricht. Die zwei geringwertigsten Bits des $\Sigma\Delta$-Modulators 11 werden zum Ansteuern des Multiplexers 6 über die Steuereinheit 12 eingesetzt. Fünf weitere Steuerbits des $\Sigma\Delta$-Modulators werden zum Programmieren des Teilerwertes des Multi-Modulus-Teilers 9 verwendet.

Im $\Sigma\Delta$-Modulator ist gegenüber einer herkömmlichen MASH-Struktur, die als Übertragungsfunktion in der Laplace-Ebene eine dreifache Polstelle bei s = 0 besitzt, im vorgeschlagenen Fall ein konjugiert komplexes Polstellenpaar

$$s_{1,2} = -\sigma 1 \pm j\omega 1$$

derart gewählt, dass die Polstelle bei derjenigen Frequenz oder bei demjenigen Frequenzbereich liegt, die beziehungsweise der aufgrund der einzuhaltenden Frequenzmaske zu reduzieren ist.

Durch die neu eingefügte, komplexe Polstelle wird das Rauschen in dem kritischen Frequenzbereich signifikant abgesenkt. Dabei bestimmt der Imaginärteil $\omega 1$ des konjugiert komplexen Polpaares $s_{1,2}$ die zu reduzierende Frequenz, während der Realteil $-\sigma 1$ das Maß der Unterdrückung bei dieser Frequenz festlegt.

Das vorgeschlagene Prinzip betrifft ein Senderkonzept mit hoher spektraler Reinheit, das entweder zur Erzeugung frequenz- und/oder phasenmodulierter Signale oder auch als Frequenz-Synthesizer verwendet werden kann. Da bei dem vorgeschlagenen Prinzip über die Phasenregelschleife die volle Modulationsbandbreite übertragen werden kann, wird ein $\Sigma\Delta$-Modulator 11 mit der Rauschübertragungsfunktion NTF(z)=1-H(z) unter Berücksichtigung der einzuhaltenden, spektralen Sendemaske laut Spezifikation verwendet. Hierzu wird wie vorgeschlagen in die Rauschübertragungsfunktion im kritischen Nachbarkanal eine komplexe Nullstelle eingefügt, die dazu führt, dass die Sendemaske trotz der höheren, zur Verfügung stehenden Bandbreite eingehalten wird.

Bei dem Ausführungsbeispiel gemäß Figur 1 ist die Phasenregelschleife mit $\Sigma\Delta$-Modulator so ausgelegt, dass sie für das DECT-System in einem Frequenzband von 1880 MHz bis 1900 MHz und zugleich für WDCT im ISM-Band in einem Frequenzbereich von 2,40 bis 2,48 GHz verwendet werden kann. Hierzu lassen sich Teilerwerte von 32 bis 63,75 mit einer Schrittweite von 0,25 einstellen.

Zur Abdeckung der beiden Frequenzbänder kann in einer Dualband-Erweiterung der PLL entweder ein zweiter VCO vorgesehen sein oder der Oszillator 4 kann mit einem umschaltbaren Frequenzband ausgestattet sein.

Die Schleifenbandbreite ist mit Vorteil so groß, daß eine Modulation über den Dateneingang 14 möglich ist.

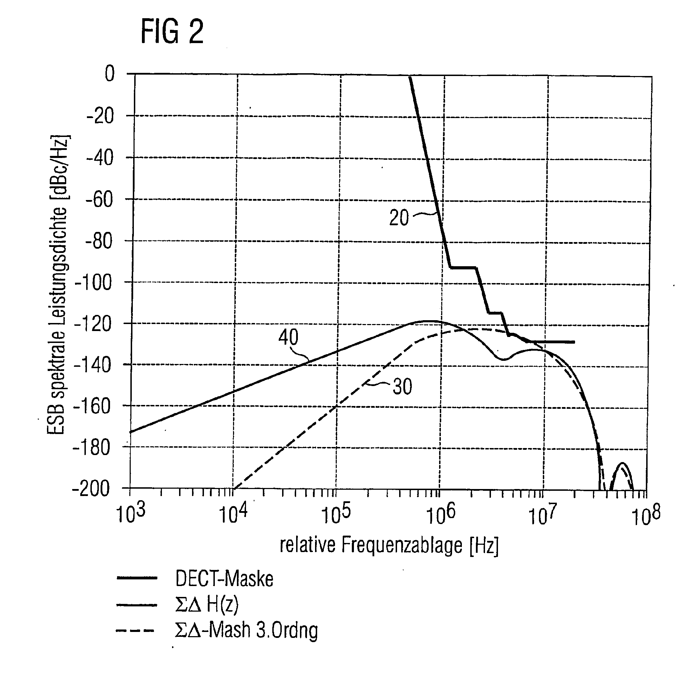

Figur 2 zeigt anhand eines Schaubildes in halblogarithmischer Darstellung die spektrale Leistungsdichte in dBc pro Hertz aufgetragen über der relativen Frequenzablage in Hertz. Die gemäß DECT-Spezifikation einzuhaltende Sendemaske ist anhand einer Kurve eingezeichnet und mit Bezugszeichen 20 versehen. Der mit einem herkömmlichen $\Sigma\Delta$-MASH-Modulator dritter Ordnung wie eingangs beschrieben erzielbare Frequenzverlauf ist mit Bezugszeichen 30 versehen. Man erkennt, dass in einem Frequenzbereich zwischen $10^6$ und $10^7$ Hz die DECT-Maske nicht optimal eingehalten werden kann. Mit Bezugszeichen 40 ist der Verlauf der mit der vorliegenden Anordnung gemäß Figur 1 erzielbaren Rauschübertragungsfunktion bezeichnet.

Man erkennt deutlich die vorteilhafte Wirkung der gemäß dem vorgeschlagenen Prinzip in den Rückführungszweig des Modulators eingefügten konjugiert komplexen Polstelle. Diese bewirkt, dass gerade im kritischen Frequenzbereich eine deutliche Absenkung der ausgesendeten spektralen Rauschleistung erzielt wird. Somit kann die DECT-Maske problemlos eingehalten werden.

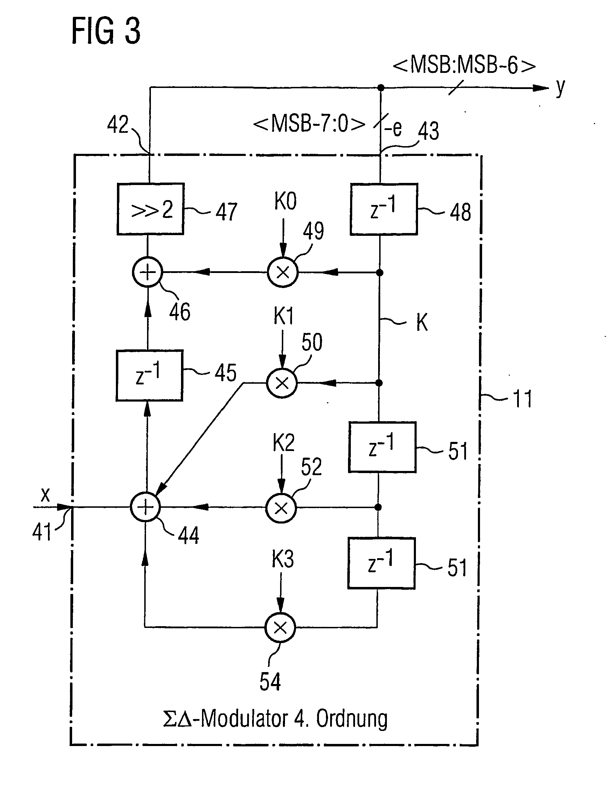

Figur 3 zeigt anhand eines Blockschaltbildes ein Ausführungsbeispiel des $\Sigma\Delta$-Modulators 11 von Figur 1, der gemäß der in der Laplace-Ebene gültigen Gleichung

$$H(s) = \frac{1}{s^2 \cdot (s + \sigma_1 + j\omega_1) \cdot (s + \sigma_2 - j\omega_2)}$$

implementiert ist.

Der $\Sigma\Delta$-Modulator vierter Ordnung gemäß Figur 3 hat einen Signaleingang 41, einen Signalausgang 42 und einen Fehlerrückkopplungseingang 43, der mit dem Ausgang 42 verbunden ist.

An den Eingang 41 ist ein erstes Summierglied 44 angeschlossen, mit drei Eingängen und einem Ausgang. Der Ausgang des Summierglieds 44 ist über ein 1/z-Glied 45 und ein zweites Summierglied 46 an einen Signalblock 47 angeschlossen, der eine Verschiebung des Digitalsignals um zwei Bit nach rechts bewirkt. Der Ausgang des Blocks 47 bildet den Ausgang 42 des Modulators. Der Fehlersignal-Rückführungseingang 43 ist über ein 1:z-Glied 48 an einen Knoten K angeschlossen. Ein Signalpfad führt vom Knoten K über einen Multiplizierer mit dem Faktor K0, der mit Bezugszeichen 49 versehen ist, an einen weiteren Eingang des zweiten Summiergliedes 46. Weiterhin ist der Knoten K über ein Multiplizierglied 50, welches mit dem Faktor K1 multipliziert, an einen Eingang des ersten Summiergliedes 44 angeschlossen. Der Knoten K ist weiterhin über ein 1/z-Glied 51 und über einen Multiplizierer 52, der mit dem Faktor K2 multipliziert, an einen Eingang des Summierers 44 angeschlossen. Schließlich ist der Ausgang des 1/z-Gliedes 51 über ein weiteres 1/z-Glied 53 und über einen Multiplizierer, der mit dem Faktor K3 arbeitet und Bezugszeichen 54 hat, an das erste Summierglied 44 angeschlossen. Der beschriebene Signalplan gemäß Figur 3 beschreibt einen $\Sigma\Delta$-Modulator 11, dessen erzielte Rauschübertragungsfunktion aufgrund der eingefügten konjugiert komplexen Polstelle dem Verlauf 40 von Figur 2 entspricht.

Bezugszeichenliste

| | |
|---|---|
| 1 | Phasenvergleicher |
| 2 | Ladungspumpenschaltung |
| 3 | Schleifenfilter |
| 4 | VCO |
| 5 | :2-Frequenzteiler |
| 6 | Multiplexer |
| 7 | Verstärker |
| 8 | Ausgang |
| 9 | Multi-Modulus-Teiler |
| 10 | Programmiereingang |
| 11 | $\Sigma\Delta$-Modulator |
| 12 | Steuereinheit |
| 13 | Trägerfrequenzeingang |
| 14 | Modulationsdateneingang |
| 15 | Verknüpfungsglied |
| 16 | FIR mit H(z) |
| 20 | DECT-Maske |
| 30 | $\Sigma\Delta$-MASH dritter Ordnung |
| 40 | $\Sigma\Delta$ gemäß Figuren 1, 3 |
| 41 | Eingang |

42 Ausgang
43 Fehlersignaleingang
44 erstes Summierglied
45 1:z-Glied
46 zweites Summierglied
47 Verschiebung um zwei Bit nach rechts
48 1:z-Glied
49 Multiplizierer
50 Multiplizierer
51 1:z-Glied
52 Multiplizierer
53 1:z-Glied
54 Multiplizierer

## Patentansprüche

1. Phasenregelschleife mit Sigma-Delta Modulator, aufweisend

- einen Phasenvergleicher (1) mit zwei Eingängen und einem Ausgang,
- einen gesteuerten Oszillator (4) mit einem Steuereingang, der an den Ausgang des Phasenvergleichers (1) angekoppelt ist,
- einen Frequenzteiler (9) mit einem Signaleingang, der an einen Ausgang des gesteuerten Oszillators (4) angekoppelt ist, mit einem Ausgang der an einen Eigang des phasenvergleichers angekoppelt ist, und mit einem Steuereingang (10) zur Vorwahl des Teilerverhältnisses des Frequenzteilers (9) und
- den Sigma-Delta-Modulator (11), der einen Ausgang, einen Summierglied und einen Rückführungszweig umfasst, wobei der Ausgang mit dem Steuereingang des Frequenzteilers (9) verbunden ist, und der Rückführungszweig den Ausgang des Summierglieds mit einem Eingang desselben Koppelt,

**dadurch gekennzeichnet, dass** der Rückführungszweig (16) so ausgelegt ist, dass die den Rückführungszweig repräsentierende, komplexe Übertragungsfunktion zumindest ein komplexes, von Null verschiedenes Polstellenpaar in der Laplace-Ebene aufweist.

2. Phasenregelschleife nach Anspruch 1,
**dadurch gekennzeichnet, dass** die in Abhängigkeit von der Laplace-Variablen s beschriebene, komplexe Übertragungsfunktion H(s) neben dem komplexen Polstellenpaar zumindest eine Polstelle bei dem Wert s=0 besitzt.

3. Phasenregelschleife nach Anspruch 1 oder 2,
**dadurch gekennzeichnet, dass** die komplexe Übertragungsfunktion des Rückführungszweiges (16) der Gleichung

$$H(s) = \frac{1}{\prod_{i=0}^{n}\left(s + \sigma_i \pm j\omega_i\right)}$$

genügt, wobei $\sigma_i$ kleiner oder gleich Null ist und zumindest ein $\sigma_i$ von Null verschieden ist.

4. Phasenregelschleife nach einem der Ansprüche 1 bis 3,
**dadurch gekennzeichnet, dass** der Frequenzteiler (9) als Multi-Modulus-Teiler ausgeführt ist.

5. Phasenregelschleife nach Anspruch 4,
**dadurch gekennzeichnet, dass**

- am Ausgang des gesteuerten Oszillators (4) ein weiterer Frequenzteiler (5) vorgesehen ist, mit mehreren Ausgängen, an denen jeweils zueinander phasenverschobene Signale bereitgestellt werden, und dass
- ein Multiplexer (6) vorgesehen ist mit mehreren, jeweils den Ausgängen des Frequenzteilers (5) zugeordneten und damit verbundenen Eingängen, mit einem Ausgang, der an den Eingang des Multi-Modulus-Teilers (9) angeschlossen ist, sowie mit einem Steuereingang.

6. Phasenregelschleife nach Anspruch 5,
**dadurch gekennzeichnet, dass** der weitere Frequenzteiler (5) als Durch-Zwei-Frequenzteiler ausgelegt ist, derart, dass die Frequenz des vom gesteuerten Oszillator an dessen Ausgang bereitgestellten Signals ($f_{vco}$) der doppelten Ausgangsfrequenz ($f_{out}$) entspricht.

7. Phasenregelschleife nach Anspruch 5 oder 6,
**dadurch gekennzeichnet, dass** der weitere Frequenzteiler (5) vier Ausgänge hat, ausgebildet zur Bereitstellung von vier zueinander in Schritten von 90 Grad phasenverschobenen Signalen mit der Ausgangsfrequenz der Phasenregelschleife.

8. Phasenregelschleife nach einem der Ansprüche 4 bis 7,
**dadurch gekennzeichnet, dass** der Multi-Modulus-Teiler (9) eine Serienschaltung mehrerer 2/3-Frequenzteilerstufen und/oder 1/2/3-Frequenzteilerstufen umfaßt, bei denen jeweils zwischen einem Frequenzteilerverhältnis von zwei und einem Frequenzteilerverhältnis von drei bzw. zwischen einem Frequenzteilerverhältnis von eins, einem Frequenzteilerverhältnis von zwei und einem Frequenzteilerverhältnis von drei umgeschaltet werden kann.

9. Phasenregelschleife nach einem der Ansprüche 1 bis 8,
**dadurch gekennzeichnet, dass** zur Kopplung des Phasenvergleichers (1) mit dem Steuereingang des gesteuerten Oszillators (4) eine Serienschaltung umfassend eine Ladungspumpenschaltung (2) und ein Schleifenfilter (3) vorgesehen ist.

**Claims**

1. Phase locked loop with sigma-delta modulator, comprising

   • a phase comparator (1) with two inputs and an output,
   • a controlled oscillator (4) with a control input coupled to the output of the phase comparator (1),
   • a frequency divider (9) with a signal input coupled to an output of the controlled oscillator (4), with an output coupled to an input of the phase comparator, and with a control input (10) for preselecting the division ratio of the frequency divider (9), and
   • the sigma-delta modulator (11) which comprises an output, a summing element and a feedback path, wherein the output is connected to the control input of the frequency divider (9) and the feedback path couples the output of the summing element to an input thereof, **characterized in that** the feedback path (16) is configured such, that the complex transfer function representing the feedback path comprises at least one complex pair of pole points which is different from zero in the Laplace plane.

2. Phase locked loop according to claim 1,
**characterized in that** the complex transfer function H(s) described depending on the Laplace variable s comprises at least a pole point at the value s=0 beside the complex pair of pole points.

3. Phase locked loop according to claim 1 or 2,
**characterized in that** the complex transfer function of the feedback path (16) satisfies the equation

$$H(s) = \frac{1}{\prod_{i=0}^{n}(s + \sigma_i \pm j\omega_i)}$$

wherein $\sigma_i$ is smaller than or equals zero and at least one $\sigma_i$ is different from zero.

4. Phase locked loop according to any of claims 1 to 3,
**characterized in that** the frequency divider (9) is realized as multi modulus divider.

5. The phase locked loop according to claim 4,

**characterized in that**

• another frequency divider (5) with several outputs at which respectively signals which are phase shifted to each other are provided, is provided at the output of the controlled oscillator (4) and
• a multiplexer (6) with several inputs which are respectively assigned and coupled to the outputs of the frequency divider (5) is provided, with an output, which is coupled to the input of the multi modulus divider (9) as well as to a control input.

**6.** The phase locked loop according to claim 5,
**characterized in that** the other frequency divider (5) is designed as by-two frequency divider such that the frequency of the signal ($f_{vco}$) provided at the output of the controlled oscillator corresponds to the double output frequency ($f_{out}$).

**7.** The phase locked loop according to claim 5 or 6,
**characterized in that** the other frequency divider (5) comprises four outputs formed for provision of four signals which are phase shifted by 90 degrees to each other having the output frequency of the phase locked loop.

**8.** The phase locked loop according to any of claims 4 to 7,
**characterized in that** the multi modulus divider (9) comprises a serial circuitry of several 2/3-frequency divider stages and/or 1/2/3-frequency divider stages, wherein respectively between a frequency divider ratio of two and a frequency divider ratio of three, or between a frequency divider ratio of one, a frequency divider ratio of two and a frequency divider ratio of three can be switched.

**9.** The phase locked loop according to any of claims 1 to 8,
**characterized in that** for coupling of the phase comparator (1) with the control input of the controlled oscillator (4), a serial circuitry comprising a charge pump circuitry (2) and a loop filter (3) are provided.

**Revendications**

**1.** Boucle d'asservissement de phase ayant un modulateur sigma-delta, comprenant

- un comparateur (1) de phase ayant deux entrées et une sortie,
- un oscillateur (4) commandé ayant une entrée de commande, qui est couplée à la sortie du comparateur (1) de phase,
- un diviseur (9) de fréquence ayant une entrée de signal, qui est couplée à une sortie de l'oscillateur (4) commandé, une sortie, qui est couplée à une entrée du comparateur de phase, et une entrée (10) de commande, pour la présélection du rapport de division du diviseur (9) de fréquence et
- le modulateur (11) sigma-delta, qui comprend une sortie, un élément de sommation et une branche de retour, la sortie étant reliée à l'entrée de commande du diviseur (9) de fréquence et la branche de retour étant couplée à la sortie de l'élément de sommation à une entrée de celui-ci,

**caractérisée en ce que**
la branche (16) de retour est conçue de manière à ce que la fonction de transfert complexe représentant la branche de retour ait au moins deux paires de pôles complexes, différents de zéro, dans le plan de Laplace.

**2.** Boucle d'asservissement de phase suivant la revendication 1,
**caractérisée en ce que**
la fonction H(s) de transfert complexe décrite en fonction de la variable de Laplace s a, outre la paire de pôles complexes, au moins un pôle à la valeur s = 0.

**3.** Boucle d'asservissement de phase suivant la revendication 1 ou 2,
**caractérisée en ce que**
la fonction de transfert complexe de la branche (16) de retour satisfait l'équation

$$H(s) = \frac{1}{\prod_{i=0}^{n}(s + \sigma_i \pm j\omega_i)}$$

dans laquelle $\sigma_i$ est inférieur ou égal à zéro et au moins un $\sigma_i$ est différent de zéro.

4. Boucle d'asservissement de phase suivant l'une des revendications 1 à 3,
   **caractérisée en ce que**
   le diviseur (9) de fréquence est réalisé en diviseur multimodule.

5. Boucle d'asservissement de phase suivant la revendication 4,
   **caractérisée en ce que**

   - il est prévu à la sortie de l'oscillateur (4) commandé un autre diviseur (5) de fréquence ayant plusieurs sorties, auxquelles sont disponibles respectivement des signaux décalés en phase les uns par rapport aux autres, et **en ce que**
   - il est prévu un multiplexeur (6) ayant plusieurs entrées affectées respectivement aux sorties du diviseur (5) de fréquence et reliées ainsi à une sortie, qui est raccordée à l'entrée du diviseur (9) multimodule ainsi qu'une entrée de commande.

6. Boucle d'asservissement de phase suivant la revendication 5,
   **caractérisée en ce que**
   l'autre diviseur (5) de fréquence est réalisé sous la forme d'un diviseur de fréquence par deux, de manière à ce que la fréquence du signal ($f_{vco}$) disponible à la sortie de l'oscillateur commandé corresponde à deux fois la fréquence ($f_{out}$) de sortie.

7. Boucle d'asservissement de phase suivant la revendication 5 ou 6,
   **caractérisée en ce que**
   l'autre diviseur (5) de fréquence a quatre sorties, est constitué pour disposer de quatre signaux déphasés les uns par rapport aux autres de 90 degrés et ayant la fréquence de sortie de la boucle d'asservissement de phase.

8. Boucle d'asservissement de phase suivant l'une des revendications 4 à 7,
   **caractérisée en ce que**
   le diviseur (9) multimodule comprend un circuit série de plusieurs étages de diviseur de fréquence 2/3 et/ou d'étages de diviseur de fréquence 1/2/3, dans lesquels respectivement on peut passer entre un rapport de division de fréquence de deux et en rapport de division de fréquence de trois ou entre un rapport de division de fréquence de un, un rapport de division de fréquence de deux et un rapport de division de fréquence de trois.

9. Boucle d'asservissement de phase suivant l'une des revendications 1 à 8,
   **caractérisée en ce que**
   pour le couplage du comparateur (1) de phase à l'entrée de commande de l'oscillateur (4) commandé, il est prévu un circuit série comprenant un circuit (2) de pompe de charge et un filtre (3) de boucle.

## FIG 1

DECT: 3,8GHz
WDCT: 4,9GHz

$f_{ref}$ 40MHz ⟶ | PFD |[1] ⟶ | CP |[2] ⟶ | ≈ |[3] ⟶ VCO (≈)[4] $f_{vco}$

$f_{div}$

**Multi-Modus Teiler**
**N=32...63**

| 2/3 | 2/3 | 2/3 | 2/3 | 1/2/3 |[9] ← | 4:1 MUX |[6] ← I / Ī / Q / Q̄ ← | :2 |[5]

**Phasen-auswahl**

10

12

8

⟶ $f_{out}$[7]
DECT: 1,9GHz
WDCT: 2,45GHz

13
x Kanalwort ⟶
d digital Daten ⟶
14

(+)  15

16  | H(z) FIR | −e

11

$\Sigma\Delta$-Modulator mit NTF=1−H(z)

$$H(s) = \frac{1}{s^2(s+\sigma_1+j\omega_1)(s+\sigma_1-j\omega_1)}$$

## FIG 2

# FIG 3

$\Sigma\Delta$-Modulator 4. Ordnung

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- US 6008703 A

- WO 0227936 A

### In der Beschreibung aufgeführte Nicht-Patentliteratur

- *ETSI EN 300 175-2 V1.5.1,* Februar 2001